# EUROPÄISCHE PATENTSCHRIFT

(11) **EP 1 042 788 B1**
(45) Veröffentlichungstag und Bekanntmachung des Hinweises auf die Patenterteilung: **29.09.2004**
(21) Anmeldenummer: 98955307.8
(22) Anmeldetag: 03.12.1998
(51) Int. Cl.: H01L 21/00

(54) **VAKUUMBEHANDLUNGSANLAGE**
VACUUM TREATMENT INSTALLATION
INSTALLATION DE TRAITEMENT SOUS VIDE

(30) Priorität: 22.12.1997 CH 294097; 13.05.1998 CH 106598
(43) Veröffentlichungstag der Anmeldung: 11.10.2000
(73) Patentinhaber: Unaxis Trading AG, 9477 Trübbach (CH)
(72) Erfinder: SCHERTLER, Roman, A-6922 Wolfurt (AT); DUBS, Martin, CH-7304 Maienfeld (CH)
(74) Vertreter: Troesch Scheidegger Werner AG
(86) Internationale Anmeldenummer: PCT/CH1998/000513
(87) Internationale Veröffentlichungsnummer: WO 1999/033093

(56) Entgegenhaltungen:
- DE-A- 19 649 412
- JP-A- 2 004 302
- JP-A- 2 102 947
- JP-A- 2 223 375
- JP-A- 4 052 275
- US-A- 5 240 583
- US-A- 5 468 299
- US-A- 5 569 967

## Beschreibung

Die vorliegende Erfindung betrifft eine Vakuumbehandlungsanlage mit einer Vakuumkammer, darin mindestens einem drehgetriebenen Teil, der über ein mindestens zwei gegenseitig abrollende Übertragungs-Rotationskörper umfassendes Getriebe mit einem motorischen Antriebsaggregat verbunden ist.

Die vorliegende Erfindung geht dabei von Problemen aus, wie sie sich bei der Vakuumbeschichtung, insbesondere von optischen Speicherscheiben, insbesondere von wiederbeschreibbaren Disks, ergeben. Die dabei gemachten Erkenntnisse lassen sich aber ohne weiteres für andere Vakuumbehandlungen einsetzen, grundsätzlich dort, wo ein Teil in einer Vakuumbehandlungskammer einer Anlage drehgetrieben werden muss.

Es ist bekannt, beispielsweise für Sputteranlagen, Substratträger an Planeten eines Planetengetriebes vorzusehen, um, mit einer Sputterquelle, unter Ausnützung möglichst hoher Anteile abgesputterten Materials an den Substraten, eine möglichst homogene Verteilung der aufgetragenen Schichtdicke zu realisieren. Für den Drehantrieb werden üblicherweise Verzahnungsgetriebe in der Vakuumatmosphäre eingesetzt.

Nachteilig sind solche Getriebe im Behandlungsvakuum der Anlage insbesondere aufgrund entstehenden Abriebes und mithin der Kontaminationsgefahr der aufgebauten Schichten, aber auch bezüglich Geräuschentwicklung, Reibungsverlusten - weil vakuumtaugliche Schmiermittel relativ schlechte Schmiereigenschaften aufweisen - und, damit einhergehend, aufgrund der kurzen Standzeiten bis Übertragungs-Rotationskörper mit Verzahnungen ersetzt werden müssen.

Aus der DE 196 49 412 ist eine Anlage mit Planetengetriebe bekannt. Die angesprochene Problematik wird dort dadurch gelöst, dass Sonnen- und Planetensystem doppelt ausgeführt sind, nämlich unverzahnt Vakuumkammer-innen- und, verzahnt, Vakuumkammer-aussenseitig. Das Vakuumkammer-innenseitige Sonnensystem wird mittels einer durch die Vakuumkammerwandung durchgeführten Welle angetrieben, während die Vakuumkammer-innenseitigen Planeten mit den Substratträgern durch magnetische Kupplungen angetrieben werden, welche durch Kammerwandungs-Abschnitte mit kammeräusseren Planeten erstellt werden.

Dieses Vorgehen mittels magnetischer Kupplungen ist äusserst aufwendig. Bezüglich magnetischer Rotationsübertrager an Pumpen wird auf die US-A-4 850 821 oder die US-A-5 449 276 hingewiesen.

Die vorliegende Erfindung setzt sich zum Ziel, eine Vakuumbehandlungsanlage eingangs genannter Art zu schaffen, bei der trotz Vorsehen eines Getriebes im Vakuum - welches, gemäss der DE 196 49 412 nach aussen verlegt ist - in der Lage ist, die oben aufgeführten Nachteile zu beheben. Zu diesem Zweck zeichnet sich die erfindungsgemässe Anlage dadurch aus, dass die mindestens zwei Übertragungs-Rotationskörper magnetisch antriebsgekoppelt sind.

Dabei wird im vorliegenden Fall unter Abrollbewegung eine Bewegung verstanden, bei der sich die erwähnten Rotationskörper so bewegen können, als würden sie aneinander abrollen, hierzu aber, aufgrund der magnetischen Antriebskopplung, nicht zwingend in Berührung stehen müssen.

In einer ersten bevorzugten Ausführungsform ist der motorische Antrieb für das erwähnte Getriebe ausserhalb der Vakuumkammer angeordnet, und es erfolgt der Antrieb des Getriebes über eine vakuumdicht durch die Vakuumkammer-Wandung durchgeführte Welle oder über eine Magnetkupplung, die durch die Wandung der Vakuumkammer vom Antrieb auf das Getriebe einwirkt. In einer weiteren bevorzugten Ausführungsform erfolgt, bei aussengelegenem Antrieb, die magnetische Antriebskopplung der gegenseitig abrollenden Rotationskörper über die Kammerwand. Dadurch wird Antriebskopplung und Übertragung durch die Kammerwand gleichzeitig realisiert.

Es weisen die Übertragungs-Rotationskörper an ihrer Peripherie - analog zur Verzahnung derartiger Rotationskörper an Verzahnungsgetrieben - Permanentmagnet-Segmente auf, welche durch gegenseitige Anziehung bzw. Abstossung die magnetische Antriebsübertragung sicherstellen, dabei bevorzugt durch gegenseitige Anziehung.

Das Getriebe ist als Planetengetriebe ausgebildet, bei welchem das Sonnenrad mit dem motorischen Antriebsaggregat wirkverbunden ist und die Planetenräder magnetisch antriebsgekoppelt sind.

Durch das Ersetzen der Verzahnungen an Verzahnungsgetrieben durch an den beteiligten Rotationskörpern in gleichmässigen Abständen angeordnete, durch, bevorzugt, gegenseitiges Anziehen oder aber Abstossen "ineinandergreifender Magnetzähne" sind - je nach Einsatzzweck - die von Verzahnungsgetrieben bekannten Getriebearten realisierbar, z.B. durch Vorsehen von "magnetisch verzahnten" Stirnrädern, Rädern mit Innenverzahnung, Kegelrädern, Schnecken, Zahnkränzen etc. Grundsätzlich wird erfindungsgemäss erreicht, dass die antriebsübertragenden Rotationskörper des Getriebes keinen Abrieb mehr ergeben, das resultierende Getriebe wesentlich reibungsärmer ist als analoge mechanische, verzahnte Getriebe und damit eine wesentlich reduzierte Antriebsleistung erfordern, dass weiter Schmierprobleme und damit auch Probleme mit reduzierter Lebensdauer massgeblich reduziert werden.

Unter Ausnützung des erfindungsgemässen Prinzips wird es zudem möglich, ein erfindungsgemässes Sputterverfahren vorzuschlagen mit kaum überbietbarer Verfahrenshomogenität an den Werkstükken.

Die Erfindung wird anschliessend anhand von Figuren beispielsweise dargestellt. Es zeigen:
- Fig. 1: eine Vakuumbehandlungsanlage mit Werkstückträger-Kalotte,
- Fig. 2: eine weitere Anlage nach Fig. 1,
- Fig. 3: ausschnittsweise eine weitere Anlage,
- Fig. 4: eine erfindungsgemässe Anlage mit Planetengetriebe,
- Fig. 5: eine weitere Ausführungsvariante einer erfindungsgemässen Anlage mit Planetengetriebe,
- Fig. 6: in einer Darstellung analog zu den Fig. 1 bis 5, schematisch, eine bevorzugte Ausführungsform einer erfindungsgemässen Anlage,
- Fig. 7: einen Längsschnitt durch einen Ausschnitt einer erfindungsgemässen Anlage, basierend auf einer Antriebsübertragung gemäss Fig. 6 und ausschnittsweise dargestellt, dies in vereinfachter Darstellung,
- Fig. 8: in Aufsicht, die Anordnung der Magnetantriebsübertragung an der Anlage gemäss Fig. 7,
- Fig. 9: ausgehend von der Anlage gemäss Fig. 7 eine detailliertere Darstellung der daran vorgesehenen Ein-/Austrittsschleuse, in einer Längsschnitt-Darstellung gemäss Fig. 7,
- Fig. 10: die Anlage gemäss den Fig. 7 bis 9 in Aufsicht und vereinfacht, bei Darstellung eines Anlagenausschnittes mit angeflanschter Sputterstation.

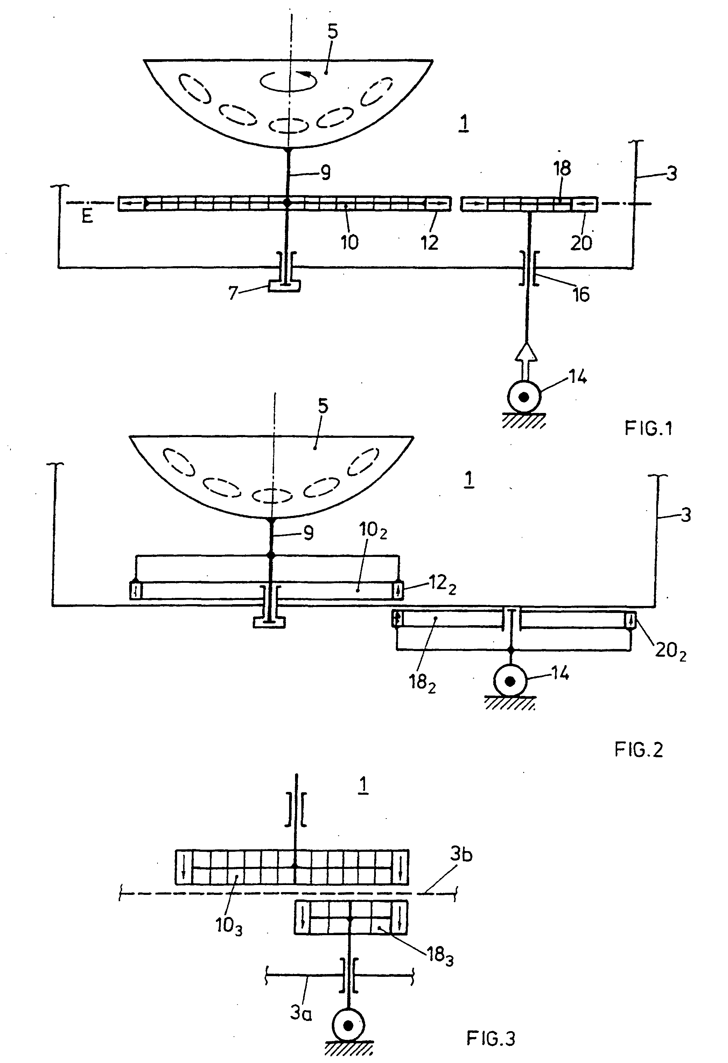

Die Abbildungen 1-3 sind für das Verständnis der Erfindung nützlich.

In Fig. 1 ist eine erste Anlage dargestellt. In einer Vakuumkammer 1 mit Vakuumkammerwand 3 ist, als darin zu drehendes Teil, beispielsweise eine Werkstückkalotte 5, wie bei 7 schematisch dargestellt, drehgelagert. Mit der Drehachse 9 der Kalotte 5 ist ein Antriebsrad 10 wirkverbunden, mit einem peripheren Permanentmagnetkranz 12. Ein Antriebsmotor 14, ausserhalb der Vakuumkammer 1 montiert, wirkt über eine vakuumdichte Drehdurchführung 16 auf ein Antriebsrad 18 mit einem peripheren Kranz 20 von Permanentmagneten. Die Räder 10 und 18 liegen in einer gemeinsamen Ebene E und berühren sich nicht. Aufgrund gegenseitiger Anziehungsund/oder Abstoss-Wirkung der sich jeweils benachbart gelegenen Permanentmagnete der Kränze 12, 20 wird der Antrieb des Aggregates 14 auf Rad 10 und damit Kalotte 5 übertragen.

Rad 10 und 18 bilden das Getriebe und rollen in obgenanntem Sinne aneinander ab.

In Fig. 2 ist in Darstellung analog zu derjenigen von Fig. 1 eine Anlage dargestellt, bei der keine vakuumdichte Drehdurchführung vorgesehen werden muss und trotzdem die Kompliziertheit der aus der DE 196 49 412 vorbekannten Anlage dadurch behoben wird, dass nicht eine magnetische Kupplung, sondern eine magnetische Antriebs-Übertragung zwischen gegenseitig abrollenden Getrieberädern durch die Kammerwandung hindurch erfolgt.

An der Antriebsachse 9 der Kalotte 5 ist ein Antriebsrad 10₂ vorgesehen mit entlang seiner Peripherie angeordnetem Permanentmagnetkranz 12₂. Während bei der Anlage gemäss Fig. 1 die magnetischen Dipole in der Ebene E, also radial zur Drehachse 9, angeordnet sind, stehen sie bei der Anlage gemäss Fig. 2 parallel zur Achse 9. Ausserhalb der Wandung 3 der Vakuumkammer 1 ist wiederum der motorische Antrieb 14 vorgesehen, auf ein ausserhalb der Kammer 1 vorgesehenes und drehgelagertes Antriebsrad 18₂ wirkend, bezüglich Anordnung des peripheren Magnetkranzes 20₂ ausgebildet wie das Rad 10₂. Wie ohne weiteres ersichtlich, erfolgt hier die rollende Antriebsübertragung von Rad 18₂ ausserhalb der Kammer auf Rad 10₂ innerhalb der Kammer über die ggf. dort für optimalen Magnetdurchgriff ausgebildete Wand 3, womit die Notwendigkeit einer vakuumdichten Drehdurchführung entfällt.

Daraus ist ersichtlich, dass der magnetische Antriebsdurchgriff von einem Rotationskörper auf den andern vollständig im Vakuum oder aber durch einen entsprechend ausgebildeten Wandungsabschnitt der Vakuumkammerwand 3 erfolgen kann.

Im Unterschied zu einer Vakuumkupplung rollen aber jedenfalls die zwei Rotationskörper relativ zueinander ab.

In Fig. 3 ist eine weitere Möglichkeit dargestellt, Rotationskörper 10₃ und 18₃ magnetisch zu koppeln. In Analogie zu den Fig. 1 und 2 kann die Vakuumkammerwand 3 wie bei 3a dargestellt vorgesehen sein oder, wie gestrichelt dargestellt, mit magnetischem Durchgriff durch die Wand, an der Stelle 3_{b}.

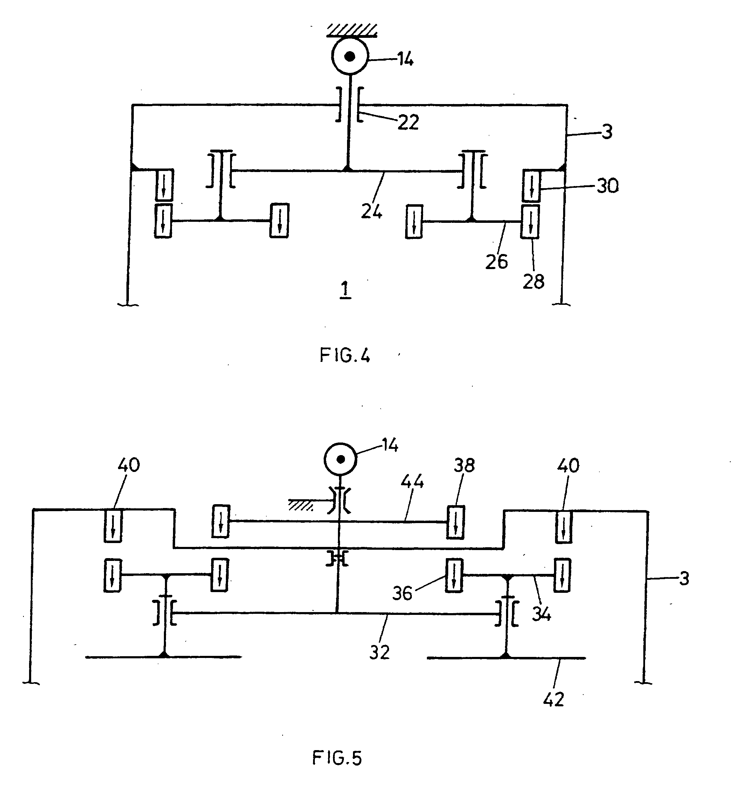

In Fig. 4 ist die Realisation der vorliegenden Erfindung an einem Planetengetriebe dargestellt. Der Antrieb 14 wirkt durch eine vakuumdichte Drehkupplung 22 auf das Sonnenrad 24 in der Vakuumkammer 1, woran die Planetenräder 26 mit (nicht dargestellt) Substratträgern drehbar gelagert sind.

Die Planetenräder 26 stehen mit peripheren Permanentmagnetkränzen 28 innerhalb der Vakuumkammer 1 mit einem stationären Magnetkranz 30 in Antriebsverbindung.

Bei einer Planetenausführungsform gemäss Fig. 5 wirkt der Antrieb 14 auf ein bezüglich der Kammerwand 3 äusseres Antriebsrad 44. Innerhalb der Vakuumkammer ist ein Stützrad 32 drehgelagert und trägt an seiner Peripherie die Planeten 34. Der periphere Magnetkranz 36 der Planetenräder steht einerseits mit einem peripheren Magnetkranz 38 des Antriebsrades 44 über die Wand 3 der Vakuumkammer in Eingriff, anderseits mit einem stationären Permanentmagnetkranz 40. Bei 42 sind die Substratträger an den Planetenrädern 34 dargestellt. Ähnlich einem Zahnrad, das zwischen einem äusseren stationären Zahnkranz (40) und einem zentralen Zahnrad (38) getrieben wird, laufen die Planetenräder 34 mit ihren Magnetkränzen 36 zwischen zentralem magnetischen Antriebsrad 44 und peripherem stationären Magnetkranz 40 um.

Bei der Ausführungsform gemäss Fig. 5 ist weder eine vakuumdichte Drehdurchführung durch die Kammerwand vorzusehen noch eine doppelte Realisation eines Planetensystems, beispielsweise gemäss der DE 196 49 412. Selbstverständlich ist es ohne weiteres möglich, beispielsweise bei der Anlage gemäss Fig. 4 die Antriebsübertragung über eine vakuumdichte Drehdurchführung 22 zu ersetzen durch eine Magnetkupplung, bei welcher Antrieb 14 durch die Wand 3 der Vakuumkammer durchführungslos auf das Sonnenrad 24 einwirkt.

Ausserdem sind weitere Ausführungen realisierbar, bei denen etwa in Fig. 5 die Radien der Magnetkränze 44 und 40 vertauscht sind, um einen anderen Drehzahlbereich für Sonnenräder und Planeten zu ermöglichen.

Für Vakuumbeschichtungen ist es jedoch vorteilhaft, wie in Fig. 5 die Planeten mit höherer Umdrehungsgeschwindigkeit zu rotieren als das Sonnenrad.

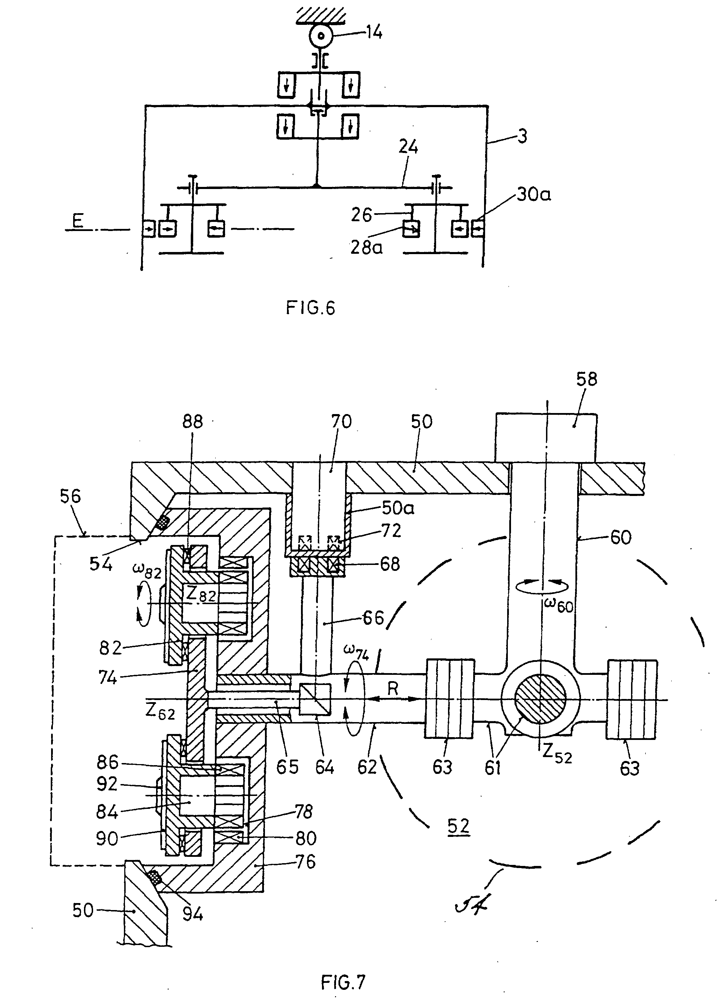

Die Anlage insbesondere gemäss Figur 2 ist insofern nachteilig, als auf die Lager, aufgrund der Antriebsübertragung, massgebliche Kippmomente wirken. Dies ergibt insbesondere bei erwünschter Miniaturisierung Probleme. Eine diesbezüglich verbesserte Lösung ist, wiederum schematisch, in Fig. 6 dargestellt. Sie ist für den Fachmann nach den bisherigen Erläuterungen ohne weiteres verständlich.

Im Unterschied zur Ausführungsform gemäss Fig. 4 sind gemäss Fig. 6 die Magnete 30a des stationären Magnetkranzes und die Magnete 28a der Planeten 26 in einer Ebene E wirkend angeordnet, welche senkrecht zu den Drehachsen des Sonnenrades 24 und der Planeten 26 steht. Damit wirken bezüglich der Lager weitestgehend und nach Massgabe der Achsenlängen nur radiale Kräfte, es werden die auftretenden Kippmomente an den Planetlagern minimalisiert.

Ausgehend vom Getriebe gemäss Fig. 6 wurde nun, wie nachfolgend erläutert, eine erfindungsgemässe Vakuumbehandlungsanlage konzipiert für die Vakuumbehandlung insbesondere von kreisscheibenförmigen Speicherplatten, dabei insbesondere von magnetooptischen Speicherplatten, aber auch von z.B. CDs, Mini Disks etc. Die Anlage ist grundsätzlich, wie erkenntlich werden wird, als Cluster-Anlage konzipiert und umfasst eine zentrale Handling-Kammer bzw. Transportkammer mit daran angeflanschten Eintritts-/Austrittsschleusen-Kammern, Behandlungskammern, ggf. weiteren Transportkammern, welche flexibel zusammengestellt werden können, um den jeweils anfallenden Bedürfnissen der Speicherplatten-Produktion gerecht zu werden.

In Fig. 7 ist, aus Übersichtsgründen vorerst wesentlich vereinfacht, im Längsschnitt, ein Teil einer derartigen Anlage dargestellt. An der ausschnittsweise dargestellten zylindrischen Wandung 50 einer zentralen Transportkammer 52 sind Öffnungen 54 vorgesehen, woran, wie gestrichelt bei 56 dargestellt, Schleusenkammern, Behandlungsstationen oder weitere Transportkammern angeflanscht werden, als Behandlungsstationen, z.B. Beschichtungskammern, Konditionierungskammern, Ätzkammern etc. Um die Achse Z₅₂ der im wesentlichen zylindrischen Transportkammer 52 wird eine Transportanordnung 60 mittels eines Drehantriebes 58 gesteuert drehgetrieben, ω₆₀. An der Transportanordnung 60 sind ein oder vorzugsweise mehrere ausladende Transportarme 61 vorgesehen, deren Teile 62 bezüglich der Achse Z₅₂ und wie mit dem Doppelpfeil R.dargestellt mittels eines gekapselten Antriebes 63, vorzugsweise balggekapselt, ausfahrbar resp. rückholbar sind. Die Antriebe 63 der Transportarme sind vorzugsweise voneinander unabhängig.

An den bezüglich der Achse Z₅₂ radial verschieblichen Armteilen bzw. -abschnitten 62 ist je ein 90°-Umlenkgetriebe 64 eingebaut. Antriebsseitig ist das Getriebe 64 mit einer parallel zur Achse Z₅₂ aufragenden Antriebsachse 66 verbunden, welche endständig die eine Magnetkupplungsscheibe 68 trägt. Ausserhalb der Kammerwand 50 ist ein Antrieb 70 mit zweiter Magnetkupplungsscheibe 72 eingebaut, welch letztere über eine entsprechend dimensionierte Wandungspartie 50a auf die Kupplungsscheibe 68 wirkt.

Abtriebsseitig wirkt das Umlenkgetriebe 64 über eine Abtriebsachse 65 auf das Sonnenrad 74. Fest mit dem Armabschnitt 62 verbunden ist ein Dichtungsteller 76 vorgesehen. Er weist, zur Achse Z₆₂ des Armes 61 konzentrisch, eine Ringnut 78 auf. An der äusseren Nut-Schulter sind, entsprechend den Magneten 30a von Fig. 6, die Magnete 80 angeordnet, den stationären Magnetkranz gemäss Fig. 6 bildend.

Das Sonnenrad 74 trägt, als Planetenräder 26 gemäss Fig. 6, Werkstückträger-Teller 82, beispielsweise deren vier. Sonnenradseitig sind an den Werkstückträger-Tellern 82 koaxial zu den Planetenachsen Z₈₂ vorragende Büchsen 84 vorgesehen, die endständig, entsprechend den Magneten 28a von Fig. 6, je einen Magnetkranz mit Magneten 86 tragen. Diese sind auf die Magnete 80 des stationären Magnetkranzes am Dichtungsteller 76 ausgerichtet. Drehgelagert sind die Werkstückträger-Teller 82, beispielsweise peripher, wie mit den Lagern 88 schematisch dargestellt. Auf den Werkstückträger-Tellern 82 sind kreisscheibenförmige Werkstücke 90, wie erwähnt insbesondere Speicherplatten, wie CDs, Mini Disks, aber insbesondere MO Disks abgelegt und bevorzugterweise magnetisch, z.B. mittels einer Zentralmaske 92 gehaltert.

Die Arbeitsweise der vorerst vereinfacht und schematisch dargestellten Anlage ist die folgende: Mit dem Radialantrieb 63 werden, vorzugsweise voneinander unabhängig, die Armabschnitte 62 vor- und rückgeholt und damit Antriebsachse 66, Dichtungsteller 76 und die weiteren mit dem Abschnitt 62 verbundenen Teile. Sollen die Werkstücke 90 in einer Behandlungskammer 56 behandelt werden, so wird die mit dem Abschnitt 62 gekoppelte Anordnung, gemäss Fig. 7, nach links gegen die Öffnung 54 vorgeschoben. Damit wird die magnetische Kopplung 72/68 erstellt, und es legt sich der Dichtungsteller 76 mit Dichtungen 94 in gefordertem Masse dicht an die Kammerwand 50 um die jeweilige Öffnung 54. Dabei werden die Werkstückträger-Teller 82 in Behandlungsposition geschoben.

Über Kammerwand 50a, Antriebsachse 66, Umlenkgetriebe 64 wird nun das Sonnenrad 74 in Drehbewegung ω₇₄ versetzt, wodurch, in Analogie zu Fig. 6, die als Planeten wirkenden Werkstückträger-Teller 82 einerseits um die Achse Z₆₂ gedreht - ω₇₄ - werden, anderseits in Eigenrotation - ω₈₂ - um die Eigenachsen Z₈₂ versetzt werden.

Bei allen an der zentralen Transportkammer 52 angeflanschten Behandlungsstationen 56, bei denen die erwähnte Doppelrotationsbewegung der Werkstückscheiben erwünscht ist, ist ein Antrieb 70 vorgesehen, der, sobald die Transportanordnung 60 einen der Arme 61 auf eine der Öffnungen 54 ausrichtet und der Abschnitt 62 ausgefahren ist, den Drehantrieb der Planetenanordnung übernimmt.

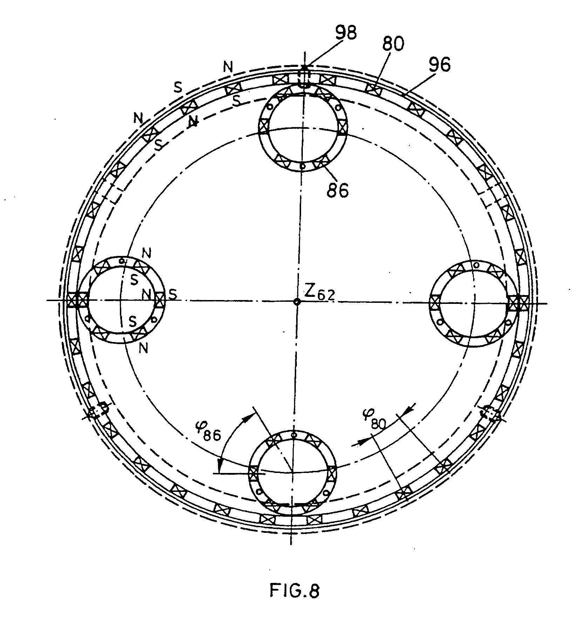

In Fig. 8 ist, in Aufsicht, die Anordnung der ortsfesten Magnete 80 sowie der Planetenmagneten 86 gemäss Fig. 7 dargestellt. Peripher aussenliegend ist um den stationären Magnetkranz bevorzugterweise ein Blechring 96 vorgesehen, welcher magnetisch abschirmend und magnetfeldverstärkend für die Antriebskopplung wirkt. Als Magnete sowohl stationärseitig wie auch planetenseitig werden bevorzugterweise Seltenerd-Magnete, dabei insbesondere Neodyn-Magnete eingesetzt. Bevorzugterweise sind sie radial und alternierend polarisiert, S, N.

Die Bogenmasse ϕ₈₆ und ϕ₈₀, wie in Fig. 8 eingetragen, sind, im Eingriffsbereich gemessen, bevorzugterweise gleich, Abweichungen von höchstens 25 % sind jedoch gegebenenfalls tolerierbar. Dadurch wird eine ruckfreie Antriebsübertragung sichergestellt. Die Anzahl je stationärseitig und planetenseitig vorgesehener Magnete 80 bzw. 86 ist geradzahlig, planetenseitig sind mindestens zwei, vorzugsweise vier und insbesondere, wie dargestellt, bevorzugt sechs und mehr Magnete vorgesehen.

Um sicherzustellen, dass eine Antriebsübertragung erfolgt, wird vorzugsweise im Bereich eines der sich relativ zueinander bewegenden Magnetkränze, vorzugsweise am stationären, ein Sensor 98 vorgesehen, mittels welchem das im ordentlichen Betrieb wechselnde Antriebsübertragungsfeld überwacht wird. Bevorzugterweise wird hierzu ein Hall-Sensor eingesetzt. Im Normalbetrieb wird ein gegebenes periodisches Signal gemessen. Blockiert das Sonnenrad oder eines der Planetenräder, so wird dies anhand bestimmter Änderungen bezüglich des Normalbetrieb-Signals detektiert. Dies erlaubt eine detaillierte Überwachung des Betriebes.

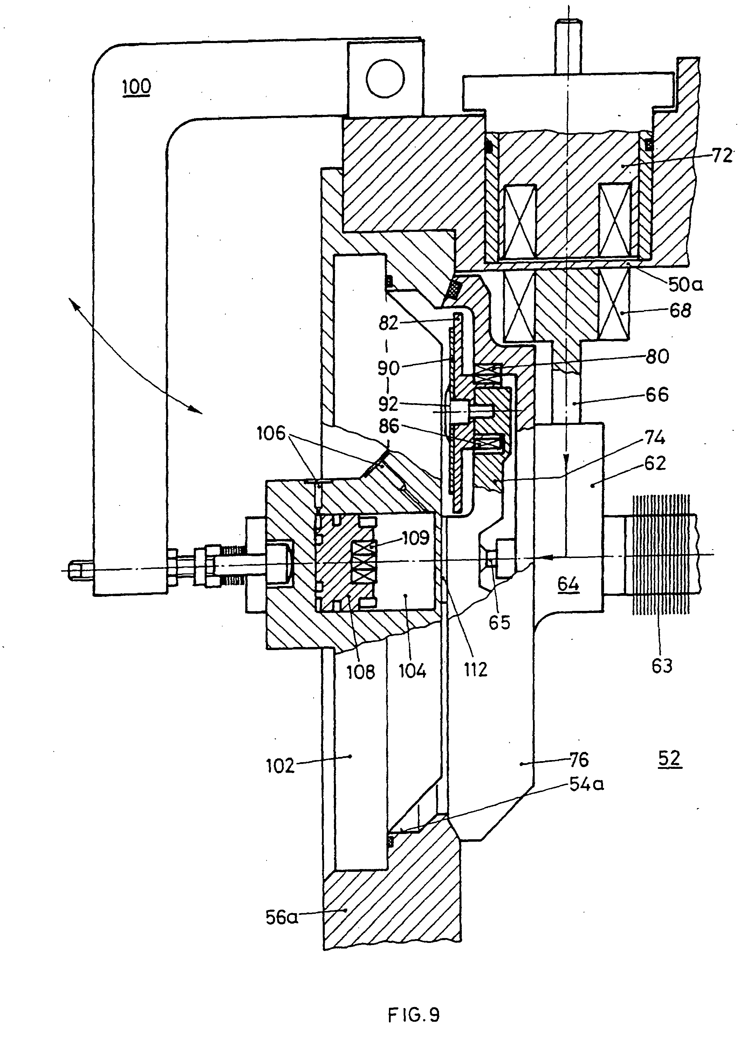

In Fig. 9 ist, weiterhin vereinfacht, jedoch etwas detaillierter als in Fig. 7, eine Längsschnittdarstellung durch einen Ausschnitt einer erfindungsgemässen Anlage dargestellt, in Analogie zur Darstellung gemäss Fig. 7, der eine angeflanschte Schleusenkammer umfasst.

Nach dem an der vereinfachten Darstellung von Fig. 7 Erläuterten verbleibt lediglich, anhand von Fig. 9, Besonderheiten an der Schleusenkammer zu erläutern.

Mittels eines Kipphebels 100 wird der Schleusenkammer-Deckel 102 von der Schleusenkammer 56a abgehoben bzw. aufgesetzt. Schleusendeckelseitige Übernahmeorgane zur Übernahme bzw. -gabe der mittels des Antriebes 72 in Sollposition gedrehten Werkstückscheiben 90 sind nicht dargestellt. In einer Variante umfassen sie am Schleusendeckel 102 Magnetanordnungen, um die Werkstücke mit den in diesem Fall aus magnetischem Material gefertigten Masken 92 von den Tellern 82 abzuziehen bzw. auf sie aufzusetzen.

Am Schleusendeckel 102 ist weiter zentral eine Kolben/Zylinderanordnung 104 vorgesehen, mit einem über pneumatische Anschlüsse 106 gesteuert verschieblichen Kolben 108 mit Permanentmagneten 109. Mit dieser Anordnung wird in bevorzugter Ausführungsvariante über eine zentrale Scheibe 112 aus magnetischem Material, das Sonnen/Planetenräder-System als Träger der Werkstücke ausgewechselt.

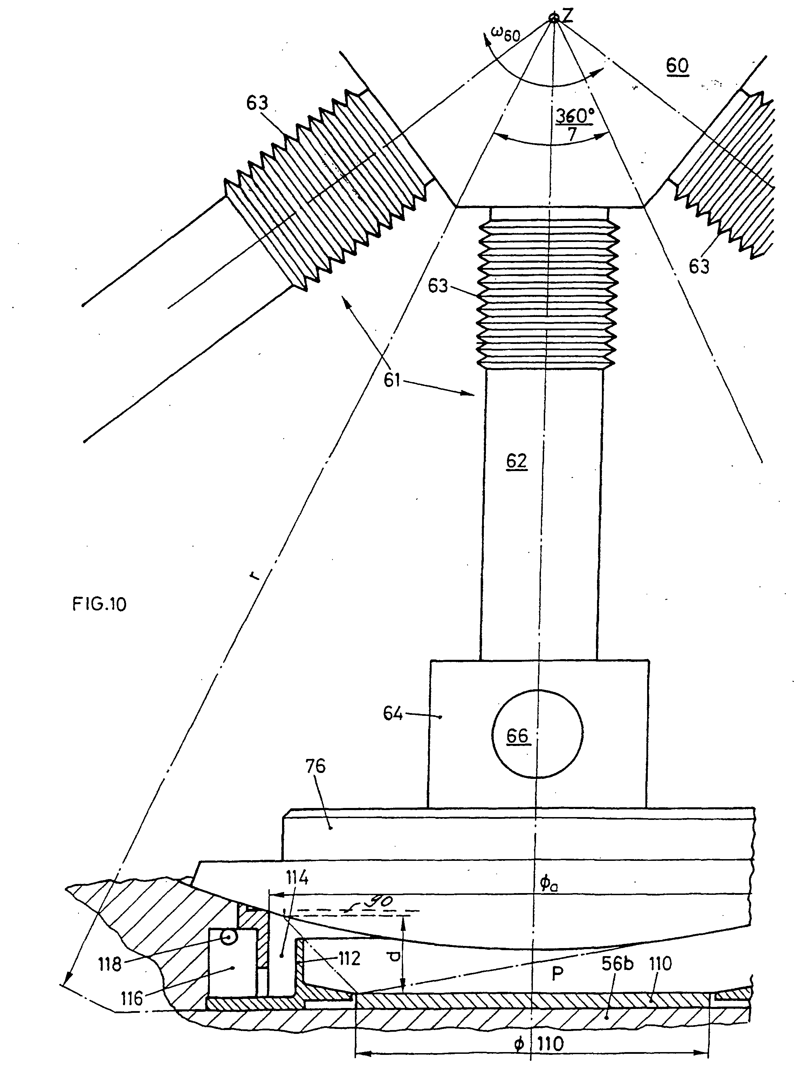

In Fig. 10 ist eine teilweise - nur statorseitige - geschnittene Darstellung eines Ausschnittes der erfindungsgemässen Anlage wiedergegeben, an dem eine Sputterstation angeflanscht ist. Es sind die bereits in Fig. 7 verwendeten Bezugszeichen für gleichwirkende Aggregate eingesetzt.

Aus Fig. 10 ist ersichtlich, wie an der erfindungsgemässen Anlage die Werkstücke 90 an einer Sputterstation 56b behandelt werden. Das Target 110 weist einen Durchmesser ∅₁₁₀ auf, der wesentlich kleiner ist als der Aussendurchmesser der Planetenanordnung. Er beträgt z.B. 127 mm, der Aussendurchmesser ∅ₐ des Planetensystems ca. 180 mm. Strichpunktiert ist der Sputterwirkungsbereich der äussersten Targetpartien dargestellt. Es ist zu betonen, dass die Werkstückscheiben, wie anhand der Fig. 7 und 8 erläutert wurde, planetenartig in Doppelrotation parallel entlang und über das Target 110 bewegt werden, was zu einer kaum zu überbietenden Homogenisierung sämtlicher Einflüsse auf die Schichtbildung an den Werkstückscheiben führt. Der Abstand d zwischen Targetneufläche und Werkstückscheiben-Oberfläche beträgt weniger als 30 mm. Der Prozessraum P wird nebst durch das Target 110 durch eine Blende 112 definiert. Um die Blende 112, über Öffnungen 114 mit dem Prozessraum verbunden, ist ein Ringkanal 116 vorgesehen, über den der Prozessraum abgepumpt wird und über den ggf. ein Arbeits- oder Reaktivgas über einen Gaseinlass 118 eingebracht wird.

Aufgrund der insbesondere aus Fig. 10 klar ersichtlichen zylindrischen, aber besonders bevorzugt sphärischen Formung der Peripherie der Dichtungsteller 76 und, entsprechend, der Kammerwand-seitigen Partien, gegen welche der Teller angelegt wird, reicht ein äusserst geringer Hub der Abschnitte 62 aus, um den

Dichtungsteller für eine Weiterdrehung gemäss ω₆₀ abzuheben.

Wie ersichtlich, ist in Fig. 10 ein 360°/7-Anschnitt aus einer Anlage mit sieben anflanschbaren und durch die Transportanordnung 60 bedienbaren Stationen, nämlich einer Schleusenstation und sechs Behandlungsstationen, dargestellt. Die vorgeschlagene Technik mit optimal homogener Behandlungswirkung für die Werkstückscheiben, wie dies insbesondere für die Herstellung von MO-Speicherscheiben erforderlich ist, führt zu einer höchst kompakten Anlage, wenn man bedenkt, dass der Aussenradius der dargestellten Sechs-Stationen-Anlage, r, lediglich 40 cm beträgt.

Die erwähnte Planetenbewegung der Werkstückscheiben planparallel zum Target 110 erlaubt, trotz bezüglich des Aussendurchmessers der Planetenanordnung und damit dem äussersten Bereich zu beschichtender Werkstückscheiben wesentlich verringertem Targetdurchmesser ∅₁₁₀, eine höchst optimale Beschichtungs-Homogenisierung. Ausserdem wird ermöglicht, teures Targetmaterial einzusparen, nämlich durch Reduzierung der Targetfläche bezüglich der zu beschichtenden Flächen.

## Patentansprüche

1. Vakuumbehandlungsanlage mit einer Vakuumkammer (1), darin einem Planetensystem mit Planetenrädern(26), die als Werkstückträger ausgebildet sind und drehbeweglich an einem Sonnenrad montiert sind, einem Antriebsaggregat (14) ausserhalb der Vakuumkammer, das mit dem Sonnenrad (24) wirkverbunden ist, wobei die Planetenräder (26) je mit einem ersten, zu ihrer jeweiligen Drehachse koaxialen Magnetkranz (28) wirkverbunden sind, **dadurch gekennzeichnet, dass** die ersten Magnetkränze (28) gemeinsam mit einem zweiten, zur Achse des Sonnenrades (24) koaxialen Magnetkranz (30) magnetisch antriebsgekoppelt sind, der an der Vakuumkammer, bezüglich der Achse des Sonnenrades, drehunbeweglich angebracht ist.

2. Anlage nach Anspruch 1, **dadurch gekennzeichnet, dass** das Antriebsaggregat (14) über eine vakuumdichte Durchführung durch die Wand der Vakuumkammer (1) auf das Sonnenrad (24)wirkt oder über eine Magnet-Kupplung über die Wand der Vakuumkammer (1).

3. Anlage nach einem der Ansprüche 1 oder 2, **dadurch gekennzeichnet, dass** die Magnetkränze (30, 28) Permanentmagnet-Segmente haben.

4. Anlage nach einem der Ansprüche 1 bis 3, **dadurch gekennzeichnet, dass** die magnetische Antriebskopplung durch magnetische Abstossung oder Anziehung, bevorzugt durch magnetische Anziehung, realisiert ist.

5. Anlage nach einem der Ansprüche 1 bis 4, **dadurch gekennzeichnet, dass** die Planetenräder als Träger für scheibenförmige Werkstücke ausgebildet sind und die Ebene der Planetenräder senkrecht zur Bewegungsrichtung (R) einer gesteuert linear beweglichen Stösselanordnung liegt, woran, endständig, das Planetensystem angeordnet ist.

6. Anlage nach Anspruch 5, **dadurch gekennzeichnet, dass** die Stösselanordnung (61, 62) an einer drehgetriebenen Transportanordnung (60) in einer Kammer (52) vorgesehen ist, wobei vorzugsweise an der Transportanordnung mehr als eine der Stösselanordnungen vorgesehen ist, vorzugsweise je unabhängig voneinander gesteuert linear (R) beweglich, und dass in der Wand der Kammer (52) mehrere Oeffnungen (54) zum Anflanschen von Werkstückbehandlungsstationen vorgesehen sind, auf welche, mit der Transportanordnung (60) und der Stösselanordnung (61, 62), die Planetenräder (82) ausrichtbar sind und zu diesen hin bzw. von diesen rückgeholt werden können, wobei weiter mindestens einem Teil der Oeffnung (54) fix eine Antriebsanordnung (70) mit Magnetkupplungsscheibe (72) zugeordnet ist, welche über eine Wandpartie (50a) der Kammerwand (50) mit einer Magnetkupplungsscheibe (68) an mindestens einem der Stössel (62) insbesondere dann in Wirkverbindung tritt, wenn mit den zugeordneten Stösseln (62) die Planetenräder (82) gegen die jeweilige Oeffnung (54) hin bewegt sind, wobei die stösselseitige Magnetkupplungsscheibe (68) das Planetensystem antreibt.

7. Anlage nach einem der Ansprüche 5 oder 6, **dadurch gekennzeichnet, dass** die Planetenräder, als Träger für scheibenförmige Werkstücke, von einem drehfest an der Stösselanordnung gelagerten Dichtungsteller (76) umgeben sind, welcher mit dem Lineartrieb der Stösselanordnung dichtend mit der Umrandung einer jeweiligen Kammeröffnung (54) in Wirkverbindung tritt und woran der zweite Magnetkranz (80) für den Planetenantrieb angeordnet ist.

8. Anlage nach einem der Ansprüche 1 bis 7, **dadurch gekennzeichnet, dass** dem Planetensystem eine Sputterquelle gegenüberliegt mit einer zur von den Planetenrädern bei ihrer Bewegung überstrichenen Fläche parallelen Sputterfläche, welche kleiner ist als die von den Planetenrädern bei ihrer Bewegung überstrichene Fläche.

9. Verfahren zur Herstellung vakuumbehandelter Werkstücke, bei welchem die Werkstücke (90) auf an einem Sonnenrad (74) drehbeweglich montierten Planetenrädern (82) eines Planetensystems in einer Vakuumkammer (50) abgelegt werden, das Sonnenrad (74) des Planetensystems von einem Antriebssystem (70) ausserhalb der Vakuumkammer (50) angetrieben wird, und die Planetenräder (82) je mit zu ihren Achsen (Z₈₂) koaxialen ersten Magnetkränzen (86) wirkverbunden sind, **dadurch gekennzeichnet, dass** man die ersten Magnetkränze (86) gemeinsam magnetisch mit einem zweiten Magnetkranz (80) koppelt, der koaxial zur Achse (Z₆₂) des Sonnenrades (74), und bezüglich der Achse (Z₆₂) des Sonnenrades drehfest an der Vakuumkammer angebracht ist, und dass man während der Bewegung (Ω₈₂) des Planetensystems die Werkstücke (90) einer Vakuumbehandlung unterzieht.

10. Verfahren nach Anspruch 9, **dadurch gekennzeichnet, dass** man während der Bewegung des Planetensystems die Werkstücke (90) sputterbeschichtet.

11. Verfahren nach einem der Ansprüche 9 oder 10, zur Herstellung vakuumbehandelter kreisscheibenförmiger Werkstücke.

12. Verfahren nach einem der Ansprüche 9 bis 11 für die Herstellung von Speicherplatten.

13. Verfahren nach einem der Ansprüche 9 bis 11 für die Herstellung optischer Speicherscheiben.

14. Verfahren nach einem der Ansprüche 9 bis 10 für die Herstellung von vakuumbehandelten Halbleiterwafern.

## Claims

1. Vacuum treatment plant with a vacuum chamber (1), in this a planetary system with planet wheels (26) formed as workpiece carriers and mount rotationally mobile on a sun wheel, a drive device (14) outside the vacuum chamber and operationally connected with the sun wheel (24), where the planet wheels (26) are each operationally connected with a first magnetic collar (28), respectively coaxial to their axis of rotation, **characterised in that** the first magnetic collars (28) are commonly magnetically drive-coupled with a second magnetic collar (30) which is coaxial to the axis of the sun wheel (24) and which is mounted on the vacuum chamber rotationally stationary in relation to the sun wheel axis.

2. Plant according to claim 1, **characterised in that** the drive device (14) acts on the sun wheel (24) via a vacuum-tight passage through the wall of the vacuum chamber (1) or via a magnetic coupling through the wall of the vacuum chamber (1).

3. Plant according to any of claims 1 or 2, **characterised in that** the magnetic collars (30, 28) have permanent magnet segments.

4. Plant according to any of claims 1 to 3, **characterised in that** the magnetic drive coupling is implemented by magnetic repulsion or attraction, preferably by magnetic attraction.

5. Plant according to any of claims 1 to 4, **characterised in that** the planet wheels are formed as carriers for disc-like workpieces and the plane of the planet wheels lies perpendicular to the movement direction (R) of a ram arrangement, linearly mobile under control, on the end of which is arranged the planetary system.

6. Plant according to claim 5, **characterised in that** the ram arrangement (61, 62) is provided on a rotationally driven transport arrangement (60) in a chamber (52), where preferably on the transport arrangement is provided more than one of the ram arrangements, preferably each linearly mobile (R) under control and independently of each other, and that in the wall of the chamber (52) are provided several openings (54) for flanging of workpiece processing stations, to which the planet wheels (82) with the transport arrangement (60) and the ram arrangement (61, 62) can be aligned and moved towards or retracted therefrom, where furthermore permanently allocated to at least part of the opening (54) is a drive device (70) with a magnetic coupling plate (72), which via a wall part (50a) of the chamber wall (50) comes into operational connection with a magnetic coupling plate (68) on at least one of the rams (60) in particular when the planet gears (82) with the allocated rams (62) are moved towards the respective opening (54), the ram-side magnetic coupling plate (68) driving the planetary system.

7. Plant according to any of claims 5 or 6, **characterised in that** the planet wheels, as carriers for disc-like workpieces, are surrounded by a sealing plate (76) which is mounted rotationally stationary on the ram arrangement and comes sealingly into operational connection by the linear drive of the ram arrangement with the periphery of the chamber opening (54) and on which is arranged the second magnetic collar (80) for the planet drive.

8. Plant according to any of claims 1 to 7, **characterised in that** opposite the planetary system is a sputter source with a sputter surface which is parallel to and smaller than the surface swept by the planet wheels during their movement.

9. Process for manufacturing vacuum-treated workpieces in which the workpieces (90) are deposited on planet wheels (82) mounted rotationally mobile on a sun wheel (74) of a planetary system in a vacuum chamber (50), the sun wheel (74) of the planetary system is driven by a drive system (70) outside the vacuum chamber (50) and the planet wheels (82) are each operationally connected with first magnetic collars (86), respectively coaxial to their axes (Z₈₂), **characterised in that** the first magnetic collars (86) are jointly magnetically coupled with a second magnetic collar (80) which is mounted on the vacuum chamber coaxial to the axis (Z₆₂) of the sun wheel (74) and rotationally stationary in relation to the axis (Z₆₂) of the sun wheel, and that during the movement (Ω₈₂) of the planetary system the workpieces (90) are subject to vacuum treatment.

10. Process according to claim 9, **characterised in that** during the movement of the planetary system the workpieces (90) are sputter-coated.

11. Process according to any of claims 9 or 10 for manufacturing vacuum-treated disc-like workpieces.

12. Process according to any of claims 9 to 11 for manufacturing storage discs.

13. Process according to any of claims 9 to 11 for manufacturing optical storage discs.

14. Process according to any of claims 9 to 10 for manufacturing vacuum-treated semiconductor wafers.

## Revendications

1. Installation de traitement sous vide comportant une chambre à vide (1) et, dans celle-ci, un système planétaire avec des roues satellites (26) qui sont conçues comme des porte-pièces et qui sont montées en rotation sur un planétaire, ainsi qu'une unité d'entraînement (14) qui est située à l'extérieur de la chambre à vide et qui est en relation fonctionnelle avec le planétaire (24), les roues satellites (26) étant en relation fonctionnelle avec des premières couronnes magnétiques respectives (28) coaxiales par rapport à leurs axes de rotation,
**caractérisée en ce que** les premières couronnes magnétiques (28) sont conjointement accouplées magnétiquement, pour leur entraînement, à une seconde couronne magnétique (30) qui est coaxiale par rapport à l'axe du planétaire (24) et qui est montée sur la chambre à vide en étant fixe en rotation par rapport à l'axe du planétaire.

2. Installation selon la revendication 1, **caractérisée en ce que** l'unité d'entraînement (14) agit sur le planétaire (24) par l'intermédiaire d'un passage étanche au vide qui traverse la paroi de la chambre à vide (1) ou d'un accouplement magnétique par l'intermédiaire de la paroi de la chambre à vide (1).

3. Installation selon la revendication 1 ou 2, **caractérisée en ce que** les couronnes magnétiques (30, 28) ont des segments formant aimants permanents.

4. Installation selon l'une des revendications 1 à 3, **caractérisée en ce que** l'accouplement d'entraînement magnétique est réalisé grâce à répulsion ou attraction magnétique, de préférence attraction magnétique.

5. Installation selon l'une des revendications 1 à 4, **caractérisée en ce que** les roues satellites sont conçues comme des supports pour des pièces en forme de plaques et le plan des roues satellites est perpendiculaire au sens de mouvement (R) d'un dispositif à piston mobile linéairement de manière commandée, à l'extrémité duquel est disposé le système planétaire.

6. Installation selon la revendication 5, **caractérisée en ce que** le dispositif à piston (61, 62) est prévu sur un dispositif de transport rotatif (60), dans une chambre (52), étant précisé que plus d'un dispositif à piston est prévu de préférence sur le dispositif de transport, de préférence en étant mobiles linéairement (R) de manière commandée indépendamment les uns des autres, et **en ce qu'**il est prévu dans la paroi de la chambre (52) plusieurs ouvertures (54) pour le bridage de stations de traitement de pièces, sur lesquelles, avec le dispositif de transport (60) et le dispositif à piston (61, 62), les roues satellites (82) sont aptes à s'aligner et peuvent être amenées vers celles-ci ou rétractées à partir de celles-ci, étant précisé également qu'il est prévu, associé de manière fixe à une partie au moins de l'ouverture (54), un dispositif d'entraînement (70) avec une plaque d'accouplement magnétique (72) qui, par l'intermédiaire d'une partie (50a) de la paroi de chambre (50), entre en relation fonctionnelle avec une plaque d'accouplement magnétique (68) au niveau de l'un au moins des pistons (62) en particulier lorsque les roues satellites (82) sont déplacées à l'aide des pistons associés (62) en direction de l'ouverture (54) correspondante, moyennant quoi la plaque d'accouplement magnétique prévue côté piston (68) entraîne le système planétaire.

7. Installation selon la revendication 5 ou 6, **caractérisée en ce que** les roues satellites, comme supports pour des pièces en forme de plaques, sont entourées par un plateau d'étanchéité (76) qui est monté fixe en rotation sur le dispositif à piston et qui, grâce à la commande linéaire du dispositif à piston, entre en relation fonctionnelle de manière étanche avec le bord d'une ouverture de chambre (54) correspondante et au niveau duquel est disposée la seconde couronne magnétique (80) pour l'entraînement planétaire.

8. Installation selon l'une des revendications 1 à 7, **caractérisée en ce qu'**il est prévu en face du système planétaire une source de pulvérisation cathodique avec une surface de pulvérisation cathodique qui est parallèle à la surface balayée par les roues satellites lors de leur déplacement et qui est plus petite que ladite surface balayée par les roues satellites lors de leur déplacement.

9. Procédé pour fabriquer des pièces traitées sous vide, selon lequel les pièces (90) sont posées sur des roues satellites (82), montées en rotation sur un planétaire (74), d'un système planétaire dans une chambre à vide (50), le planétaire (74) du système planétaire est entraîné par un système d'entraînement (70) prévu à l'extérieur de la chambre à vide (50) et les roues satellites (82) sont en relation fonctionnelle avec des premières couronnes magnétiques respectives (86) coaxiales par rapport à leurs axes (Z₈₂),
**caractérisé en ce qu'**on accouple magnétiquement, conjointement, les premières couronnes magnétiques (86) à une seconde couronne magnétique (80) qui est coaxiale par rapport à l'axe (Z₆₂) du planétaire (74) et qui est montée sur la chambre à vide en étant fixe en rotation par rapport à l'axe (Z₆₂) du planétaire, et **en ce que** pendant le mouvement (Ω₈₂) du système planétaire, on soumet les pièces (90) à un traitement sous vide.

10. Procédé selon la revendication 9, **caractérisé en ce que** pendant le mouvement du système planétaire, on recouvre les pièces (90) par pulvérisation cathodique.

11. Procédé selon la revendication 9 ou 10 pour fabriquer des pièces en forme de disques traitées sous vide.

12. Procédé selon l'une des revendications 9 à 11 pour fabriquer des disques de mémoire.

13. Procédé selon l'une des revendications 9 à 11 pour fabriquer des disques optiques numériques.

14. Procédé selon l'une des revendications 9 à 10 pour fabriquer des plaquettes de semi-conducteurs traitées sous vide.
